# EUROPÄISCHE PATENTSCHRIFT

(11) **EP 1 405 377 B1**
(45) Veröffentlichungstag und Bekanntmachung des Hinweises auf die Patenterteilung: **14.09.2011**
(21) Anmeldenummer: 02752999.9
(22) Anmeldetag: 09.07.2002
(51) Int. Cl.: H01R 13/66

(54) **LED-MODUL FÜR BELEUCHTUNGSVORRICHTUNGEN**
LED-MODULE FOR ILLUMINATING DEVICES
MODULE A DIODES ELECTROLUMINESCENTES POUR DISPOSITIFS D'ECLAIRAGE

(30) Priorität: 09.07.2001 DE 10133255
(43) Veröffentlichungstag der Anmeldung: 07.04.2004
(73) Patentinhaber: OSRAM Opto Semiconductors GmbH, 93055 Regensburg (DE)
(72) Erfinder: BLÜMEL, Simon, 84069 Schierling (DE); HACKER, Christian, 93049 Regensburg (DE); STOLZENBERG, Andreas, 93161 Sinzing (DE)
(74) Vertreter: Epping - Hermann - Fischer
(86) Internationale Anmeldenummer: PCT/DE2002/002510
(87) Internationale Veröffentlichungsnummer: WO 2003/007389

(56) Entgegenhaltungen:
- EP-A- 1 107 389
- WO-A-99/53234
- DE-A- 4 136 839
- DE-C1- 19 914 281
- US-A- 4 601 528

## Beschreibung

Die vorliegende Erfindung betrifft eine LED-Modul für Beleuchtungsvorrichtungen gemäß Patentanspruch 1 sowie Beleuchtungsvorrichtungen mit einem derartigen LED-Modul.

Bei der Herstellung von Leuchten werden üblicherweise vorgefertigte Leuchtmittel in ein Leuchtengehäuse montiert. In der Praxis werden hierbei möglichst einfache Leuchtmittel-Module verwendet, die ohne großes technisches Know-how zusammengefügt und in Leuchten eingebaut werden können.

Bisher bekannte Leuchtmittel-Module, die als Leuchtmittel Leuchtdioden (kurz LED's) verwenden, erfordern jedoch vom Leuchtenhersteller besondere Kenntnisse im elektrischen und mechanischen Bereich, um die vorgefertigten LED-Module in ein Leuchtengehäuse einzusetzen und anzuschließen. So sind beispielsweise LED-Module bekannt, die auf einer Trägerplatte angeordnete LED's aufweisen, wobei die Trägerplatte wahlweise in vorbestimmte Nutzen gebrochen werden kann, um eine Veränderung der Modulgeometrie zu ermöglichen. Die gebrochenen Einzelmodule müssen anschließend über eine Lötverbindung elektrisch kontaktiert werden.

Aus der Druckschrift EP 1 107 389 A ist eine Beleuchtungseinrichtung für ein Fahrzeug mit einem Fahrzeug-Leuchtengehäuse bekannt, in dem zumindest eine LED aufgenommen ist. Eine austauschbare LED-Einheit, auf der die zumindest eine LED fest angeordnet ist, besitzt elektrische Kontakte und ist derart lösbar im Fahrzeug-Leuchtengehäuse aufgenommen und gehalten, dass beim Einbau der LED-Einheit eine elektrische Verbindung zwschen den elektrischen Kontakten einerseits und den Kontakten des Gehäuses andererseits herstellbar ist.

Es ist deshalb eine Aufgabe der vorliegenden Erfindung, eine Beleuchtungsvorrichtung mit LED-Modulen anzugeben, bei dem die LED-Module in einfacher Weise sowohl elektrisch als auch mechanisch in die Beleuchtungsvorrichtung eingebaut bzw. angeschlossen werden können. Weiter soll das LED-Modul auch eine größtmögliche Flexibilität bezüglich seiner Einsatzmöglichkeiten gewährleisten.

Diese Aufgaben werden durch eine Beleuchtungsvorrichtung mit den Merkmalen von Patentanspruch 1 gelöst. Weitere vorteilhafte Ausgestaltungen und Weiterbildungen der Erfindung sind Gegenstand der Unteransprüche 2 bis 14.

Das LED-Modul der vorliegenden Erfindung weist mehrere auf einer Trägerplatte angeordnete Leuchtdioden auf, wobei die Trägerplatte außerdem wenigstens eine elektrische Anschlußvorrichtung zum elektrischen Anschluss des LED-Moduls und eine Befestigungsvorrichtung zum mechanischen Befestigen des LED-Moduls in einer Beleuchtungsvorrichtung aufweist. In der Beleuchtungsvorrichtung mit mehreren derartigen LED-Modulen dienen die elektrischen Anschlußvorrichtungen auch der elektrischen Verbindung der einzelnen LED-Module untereinander und die einzelnen LED-Module können über die Befestigungsvorrichtungen auch mechanisch miteinander verbunden werden. Das erfindungsgemäße LED-Modul kann beim Einbau in eine Beleuchtungsvorrichtung auf einfache Weise durch entsprechend ausgebildete Kontakt- und Befestigungsvorrichtungen an der Beleuchtungsvorrichtung, welche in die elektrischen Anschlußvorrichtungen bzw. die Befestigungsvorrichtungen des LED-Moduls eingreifen, angeschlossen bzw. befestigt werden. Bei Ausbildung kleiner LED-Module ist gleichzeitig eine große Flexibilität gewährleistet, da mehrere solcher LED-Module nahezu beliebig und in einfacher Weise kombiniert werden können.

Der elektrische Anschluss des LED-Moduls für die Stromversorgung und die Ansteuerung des LED-Moduls erfolgt vorzugsweise über einen Steckverbinder, der in eine entsprechende elektrische und mechanische Kontaktierung der elektrischen Anschlußvorrichtung des LED-Moduls eingreift. Der Steckverbinder weist dabei bevorzugt ein Mittel zum dichten Verschließen der elektrischen Anschlußvorrichtung zum Schutz gegen Umwelteinflüsse auf.

Weiter kann das LED-Modul ein Gehäuse aufweisen, das die auf der Trägerplatte angeordneten Leuchtdioden und gegebenenfalls weiteren elektronischen Komponenten umgibt. Je nach Anwendungsfall kann dieses Gehäuse verschiedenen IP-Anforderungen bezüglich seiner Dichtheit genügen.

Ein bevorzugtes Ausführungsbeispiel eines LED-Moduls weist außerdem eine Optik zur Beeinflussung der Abstrahlcharakteristik der Leuchtdioden auf. Diese Optik kann mit dem Gehäuse verbunden oder in das Gehäuse integriert sein oder alternativ auch mit der Trägerplatte verbunden sein.

Werden beim Einbau in eine Beleuchtungsvorrichtung nicht sämtliche an dem LED-Modul vorgesehenen elektrischen Anschlußvorrichtungen benutzt, so können diese unbenutzten elektrischen Anschlußvorrichtungen mittels geeigneter Blindstecker (dicht) verschlossen werden.

Die Erfindung wird nachfolgend anhand eines bevorzugten Ausführungsbeispiels unter Bezugnahme auf die beiliegende Zeichnung näher beschrieben. Darin zeigen:
- Fig. 1: eine schematische Darstellung einer Trägerplatte eines LED-Moduls gemäß der vorliegenden Erfindung;
- Fig. 2: eine schematische Darstellung eines LED-Moduls ge- mäß der vorliegenden Erfindung in perspektivischer An- sicht von oben;
- Fig. 3: eine schematische Darstellung eines LED-Moduls ge- mäß der vorliegenden Erfindung in perspektivischer An- sicht von unten; und
- Fig. 4: einen Steckverbinder zum elektrischen Anschluss ei- nes LED-Moduls gemäß der vorliegenden Erfindung.

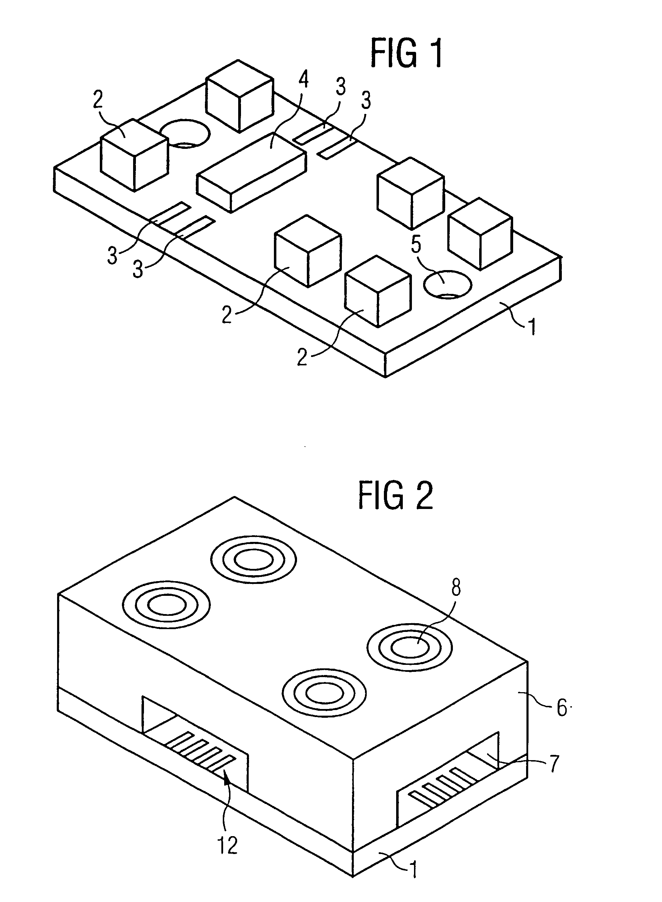

In Fig. 1 ist zunächst eine Trägerplatte 1 eines LED-Moduls gemäß der vorliegenden Erfindung in stark vereinfachter Form dargestellt. Auf der Trägerplatte 1 sind mehrere Leuchtdioden 2 und eine Steuervorrichtung 4 zur Ansteuerung der Leuchtdioden 2 angeordnet. Die Trägerplatte 1 kann grundsätzlich aus einem beliebigen Material gefertigt sein, in das geeignete Leiterbahnen und Kontaktstellen eingearbeitet oder auf dem diese aufgebracht sind. Geeignete Materialien sind zum Beispiel herkömmliche Platinenmaterialien und moderne Kunststoffmaterialien. Neben den LED's 2 und der Steuervorrichtung 4 können selbstverständlich auch noch andere elektronischen oder optoelektronischen Bauteile auf der Trägerplatte 1 montiert sein. Außerdem kann die Ansteuerung der LED's alternativ auch extern erfolgen, so dass die Trägerplatte 1 keine eigene Steuervorrichtung 4 aufweisen muss.

Die Energieversorgung des LED-Moduls und die Zufuhr von Steuerdaten erfolgt über elektrische Kontakteinrichtungen 3 auf der Trägerplatte 1. Im einfachsten Fall besteht diese elektrische Kontakteinrichtung 3 aus nur zwei Kontakten. Für eine separate Ansteuerung einzelner LED's oder LED-Gruppen bzw. deren Steuervorrichtungen 4 oder für einen gemeinsamen Anschluss mehrere LED-Module sind allerdings mehr als zwei Kontakte für die elektrische Kontakteinrichtung 3 notwendig.

Wie in Fig. 2 dargestellt, bildet die elektrische Kontakteinrichtung 3 zusammen mit einer mechanischen Kontakteinrichtung 7 die elektrische Anschlußvorrichtung 12 des LED-Moduls. Vorzugsweise sind mehrere solcher elektrischen Anschlußvorrichtungen 12 an verschiedenen Stellen an einem LED-Modul vorgesehen, um eine größtmögliche Flexibilität beim Anschluss des LED-Moduls in einer Beleuchtungsvorrichtung oder bei der Verbindung mehrerer LED-Module miteinander zu gewährleisten.

Das in Fig. 2 gezeigte Ausführungsbeispiel eines LED-Moduls weist ein Gehäuse 6 auf, das auf der Trägerplatte 1 aufgebracht ist und die LED's 2 und die Steuervorrichtung 4 auf der Trägerplatte 1 umgibt. Je nach gewünschter Anwendung des LED-Moduls kann das Gehäuse 6 verschiedenen IP-Anforderungen genügen, so dass das LED-Modul auch in ungünstigen Umgebungsbedingungen im Außenbereich oder in Bereichen mit hoher Luftfeuchtigkeit eingesetzt werden kann. Das Gehäuse 6 kann zum Beispiel durch Einbetten der Trägerplatte 1 mit einem geeigneten, vorzugsweise lichtdurchlässigen Kunststoffmaterial ausgebildet sein. Zusätzlich oder anstelle der dichten Ausführungsform des Gehäuses 6 kann das LED-Modul auch mit einer Schutzbeschichtung, beispielsweise aus Lack, versehen sein.

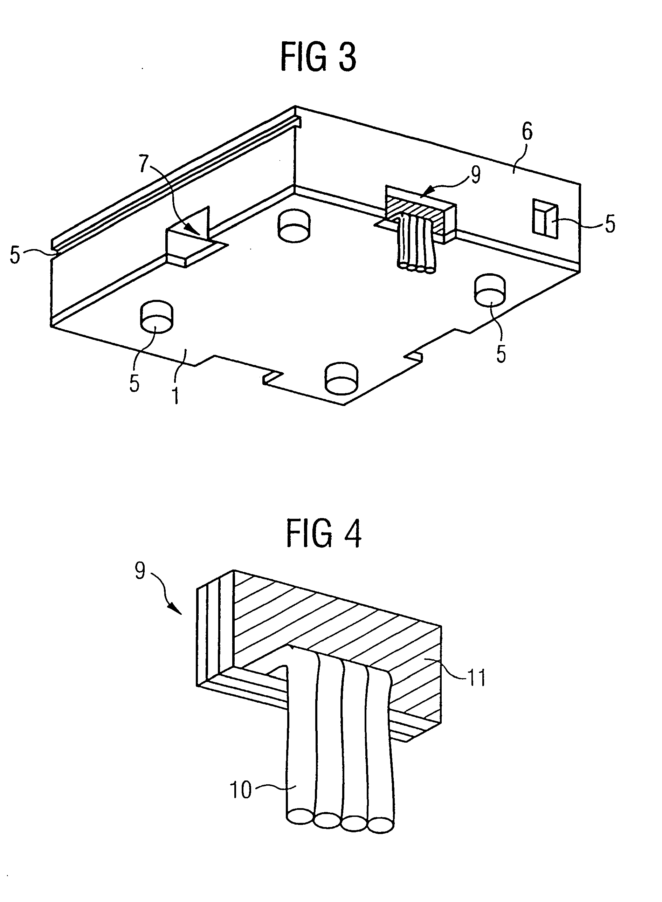

Die mechanische Kontakteinrichtung 7 der elektrischen Anschlußvorrichtung 12 ist bei dem in Fig. 2 dargestellten Ausführungsbeispiel mittels einer Ausnehmung in dem Gehäuse gebildet, die über der elektrischen Kontakteinrichtung 3 auf der Trägerplatte 1 vorgesehen ist. Der elektrische Anschluss des LED-Moduls erfolgt in diesem Fall über einen Steckverbinder 9, der in die Ausnehmung 7 einführbar ist und darin zum Beispiel über eine Rastvorrichtung (nicht dargestellt) lösbar befestigt wird und dessen elektrische Kontakte mit der elektrischen Kontakteinrichtung 3 des LED-Moduls in Kontakt gebracht werden, wie dies in Fig. 3 gezeigt ist.

Um den dichten Einschluss der elektronischen Komponenten 2, 4 in dem Gehäuse 6 aufrechtzuerhalten, kann der Steckverbinder 9 mit einem Mittel 11 zum Abdichten der elektrischen Anschlußvorrichtung 12 versehen sein. Dieses Mittel 11 zum Abdichten kann zum Beispiel eine umlaufende Dichtlippe an dem Steckverbinder 9 sein, deren Außenabmessungen etwas größer bemessen sind als die Innenmaße der Ausnehmung 7 der elektrischen Anschlußvorrichtung 12 am LED-Modul.

Sind an einem LED-Modul mehrere elektrische Anschlußvorrichtungen 12 vorhanden, von denen beispielsweise nur eine für den Anschluss an der Beleuchtungsvorrichtung benutzt wird, so können in die unbenutzten elektrischen Anschlußvorrichtungen 12 geeignete Blindstecker eingesetzt werden, welche die elektrischen Anschlußvorrichtungen 12 zur Aufrechterhaltung der Dichtheit des Gehäuses 6 dicht verschließen.

Anstelle der in den Fig. 2 bis 4 gezeigten Ausführungsform der elektrischen Anschlußvorrichtung 12 können alternativ auch aus dem Gehäuse 6 Kabelverbindungen herausgeführt sein, die einerseits mit den elektrischen Kontakteinrichtungen 3 auf der Trägerplatte 1 und andererseits zum Beispiel mit einem Steckverbinder verbunden sind. Die Kabelverbindungen sind an der elektrischen Kontakteinrichtung 3 der Trägerplatte 1 angelötet und aus dem Gehäuse 6 vorzugsweise durch eine abgedichtete Durchführung herausgeführt. Der Steckverbinder stellt den Gegenstecker für den Steckverbinder 9 der Beleuchtungsvorrichtung dar.

Die elektrischen Anschlußvorrichtungen 12 können in gleicher Weise zur elektrischen Verbindung mehrerer LED-Module benutzt werden, die gemeinsam in eine Beleuchtungsvorrichtung eingebaut werden sollen. Die so ausgeführten elektrischen Verbindungen dienen sowohl der Energieversorgung als auch der Übertragung von Steuerdaten zu den einzelnen LED-Modulen, so dass nur ein Anschluss von einem der mehreren LED-Module zu der Beleuchtungsvorrichtung erfolgen muss.

Neben den elektrischen Anschlußvorrichtungen 12 weist das LED-Modul auch zumindest eine Befestigungsvorrichtung 5 auf. Wie in Fig. 1 dargestellt, kann diese Befestigungsvorrichtung 5 beispielsweise ein Loch in der Trägerplatte 5 sein, in das ein Stift mit Presspassung eingepasst oder in das (im Falle eines Gewindelochs) eine Schraube eingeschraubt wird. Wie in Fig. 3 gezeigt, sind aber auch andere Befestigungsvorrichtungen 5 denkbar. So können die Befestigungsvorrichtungen 5 sowohl an der Trägerplatte 1 als auch an dem mit der Trägerplatte 1 verbundenen Gehäuse 6 vorgesehen sein. Die Befestigungsvorrichtungen 5 können als Löcher, Gewindelöcher, Stifte, Nuten, Vertiefungen und dergleichen ausgebildet sein, in die entsprechende Stifte, Schrauben, Rastvorrichtungen und dergleichen eingreifen, um das LED-Modul in einer Beleuchtungsvorrichtung vorzugsweise lösbar zu befestigen. Die gleichen Befestigungsvorrichtungen 5 können ebenso zum Verbinden mehrerer LED-Module benutzt werden, die gemeinsam in eine Beleuchtungsvorrichtung eingebaut werden sollen.

Weiter kann das LED-Modul mit einer strahlformenden oder strahlumlenkenden Optik 8 ausgestattet sein, um die Abstrahlcharakteristik der LED's 2 auf der Trägerplatte 1 zu beeinflussen. Diese Optik 8 kann beispielsweise mit dem Gehäuse 6 verbunden oder in das Gehäuse 6 integriert sein. In einer bevorzugten Ausführungsform wird die Optik 8 einteilig mit dem Gehäuse 6 aus einem geeigneten Kunststoffmaterial gegossen. Alternativ kann die Optik auch an der Trägerplatte 1, beispielsweise durch Kleben, Schappverbindungen, Presspassung oder dergleichen, befestigt werden.

Die Optik 8 kann ebenso aus einzelnen optischen Strukturen bestehen, die jeweils einer oder mehreren LED's zugeordnet sind.

Das oben beschriebene LED-Modul gemäß der vorliegenden Erfindung kann vom Hersteller von Beleuchtungsvorrichtungen auf einfache Weise mechanisch in einer Beleuchtungsvorrichtung befestigt und zum Beispiel über geeignete Steckverbinder elektrisch angeschlossen werden. Die elektrische Anschlußvorrichtung und die Befestigungsvorrichtung bieten dem Benutzer ferner die Möglichkeit, auf einfache Weise mehrere solcher LED-Module zu kombinieren, um bei der Gestaltung der Beleuchtungsvorrichtungen eine größere Flexibilität zu erhalten.

Selbstverständlich ist die vorliegende Erfindung nicht auf das oben beschriebene und in den Figuren dargestellte Ausführungsbeispiel eines LED-Moduls beschränkt, vielmehr können einige Modifikationen vorgenommen werden ohne den durch die Ansprüche definierten Schutzbereich zu verlassen. Insbesondere bestehen bezüglich der Form, der Größe und des Materials des LED-Moduls und seiner Bauteile kaum Einschränkungen. Auch die Art und die Anordnung der elektrischen Anschlußvorrichtungen und der mechanischen Befestigungsvorrichtungen sind nicht auf die gezeigten Ausführungsformen eingeschränkt. Weiter können grundsätzlich beliebige Steckverbinder oder entsprechende elektrische Anschlussverbindungen verwendet werden.

## Patentansprüche

1. Beleuchtungsvorrichtung mit mehreren LED-Modulen mit jeweils mehreren auf einer Trägerplatte angeordneten Leuchtdioden,
wobei
die Trägerplatte (1) wenigstens eine elektrische Anschlußvorrichtung (12) zum steckbaren und vorzugsweise lösbaren elektrischen Anschluss des LED-Moduls und eine Befestigungsvorrichtung (5) zum vorzugsweise lösbaren Befestigen des LED-Moduls in der Beleuchtungsvorrichtung aufweist,
die LED-Module ein Gehäuse (6) aufweisen, das die auf der Trägerplatte (1) angeordneten Leuchtdioden umgibt,
die Beleuchtungsvorrichtung eine Befestigungsvorrichtung, welche das zugehörige Gegenstück zur Befestigungsvorrichtung (5) der LED-Module darstellt, und eine elektrische Anschlußvorrichtung (9) aufweist, welche das zugehörige Gegenstück zur elektrischen Anschlußvorrichtung (12) der LED-Module darstellt,
die LED-Module über die elektrischen Anschlußvorrichtungen (12) elektrisch miteinander verbunden sind, und die jeweilige elektrische Anschlußvorrichtung (12) eine elektrische Kontakteinrichtung (3) und eine mechanische Kontakteinrichtung (7) aufweist, so dass die LED-Module über die elektrische Anschlußvorrichtung (12) mit einem elektrischen Steckverbinder (9) verbunden werden können, und
die mechanische Kontakteinrichtung (7) der elektrischen Anschlußvorrichtung (12) mittels einer Ausnehmung (7) in dem Gehäuse (6) gebildet ist, die über der elektrischen Kontakteinrichtung (3) auf der Trägerplatte (1) vorgesehen ist.

2. Beleuchtungsvorrichtung nach Anspruch 1,
**dadurch gekennzeichnet,**
**dass** die LED-Module über die Befestigungsvorrichtungen der einzelnen LED-Module mechanisch miteinander verbindbar sind.

3. Beleuchtungsvorrichtung nach Anspruch 1 oder 2,
**dadurch gekennzeichnet,**
**dass** der Steckverbinder (9) in die Ausnehmung (7) in dem Gehäuse (6) einführbar ist.

4. Beleuchtungsvorrichtung nach einem der vorhergehenden Ansprüche,
**dadurch gekennzeichnet,**
**dass** die LED-Module weiter eine Optik (8) zur Beeinflussung der Abstrahlcharakteristik der Leuchtdioden (2) aufweisen.

5. Beleuchtungsvorrichtung nach Anspruch 4,
**dadurch gekennzeichnet,**
**dass** die Optik (8) mit dem Gehäuse (6) verbunden oder in das Gehäuse (6) integriert ist.

6. Beleuchtungsvorrichtung nach einem der vorhergehenden Ansprüche,
**dadurch gekennzeichnet,**
**dass** auf der Trägerplatte (1) eine Steuerschaltung (4) zur Ansteuerung der Leuchtdioden (2) vorgesehen ist.

7. Beleuchtungsvorrichtung nach einem der vorhergehenden Ansprüche,
**dadurch gekennzeichnet,**
**dass** die Befestigungsvorrichtung der LED-Module (5) eine lösbare Befestigung der LED-Module an der Beleuchtungsvorrichtung erlaubt.

8. Beleuchtungsvorrichtung nach einem der vorhergehenden Ansprüche,
**dadurch gekennzeichnet,dass**
das Gehäuse (6) aus einem Kunststoffspritzteil gefertigt ist.

9. Beleuchtungsvorrichtung nach einem der vorhergehenden Ansprüche,
**dadurch gekennzeichnet,**
**dass** die mehreren LED-Module über die Befestigungsvorrichtungen der LED-Module auch mechanisch miteinander verbunden sind.

10. Beleuchtungsvorrichtung nach einem vorhergehenden Ansprüche,
**dadurch gekennzeichnet,**
**dass** die elektrische Anschlußvorrichtung (9) der Beleuchtungsvorrichtung ein Steckverbinder ist.

11. Beleuchtungsvorrichtung nach einem der vorhergehenden Ansprüche,
**dadurch gekennzeichnet,**
**dass** die elektrische Anschlußvorrichtung (9) der Beleuchtungsvorrichtung ein Mittel (11) zum Abdichten der elektrischen Anschlußvorrichtung (12) der LED-Module aufweist.

12. Beleuchtungsvorrichtung nach einem der vorhergehenden Ansprüche,
**dadurch gekennzeichnet,**
**dass** die Beleuchtungsvorrichtung weiter Blindstecker zum dichten Verschließen nicht benutzter elektrischer Anschlußvorrichtungen (12) der LED-Module aufweist.

## Claims

1. Illumination system having a plurality of LED modules each having a plurality of light-emitting diodes arranged on a carrier plate,
the carrier plate (1) has at least one electrical connecting device (12) for pluggable and preferably detachable electrical connection of the LED module, and a fastening device (5) for fastening the LED module preferably detachably in an illumination system,
the LED modules have a housing (6) that surrounds the light-emitting diodes (2) arranged on the carrier plate (1),
the illumination system has a fastening device, that constitutes the associated counterpart to the fastening device (5) of the LED modules, and an electrical connecting device (9) that constitutes the associated counterpart to the electrical connecting device (12) of the LED modules
the LED modules are electrically interconnected via the electrical connecting devices (12), and
the respective electrical connecting device (12) has an electric contact device (3) and a mechanical contact device (7) such that the LED modules can be connected to an electric plug-in connector (9) via the electrical connecting device (12), and
the mechanical contact device (7) of the electrical connecting device (12) is formed by means of a recess (7) in the housing (6) that is provided via the electric contact device (3) on the carrier plate (1).

2. Illumination system according to Claim 1, **characterized in that** the LED modules are mechanically interconnected via the fastening devices of the individual LED modules.

3. Illumination system according to Claim 1 or 2, **characterized in that** the plug-in connector (9) can be inserted into the recess (7) in the housing (6).

4. Illumination system according to one of the preceding claims, **characterized in that** the LED modules further have an optical system (8) for influencing the emission characteristic of the light-emitting diodes (2).

5. Illumination system according to Claim 4, **characterized in that** the optical system (8) is connected to the housing (6), or is integrated in the housing (6).

6. Illumination system according to one of the preceding claims, **characterized in that** a control circuit (4) for driving the light-emitting diodes (2) is provided on the carrier plate (1).

7. Illumination system according to one of the preceding claims, **characterized in that** the fastening device of the LED modules (5) permits detachable fastening of the LED modules on the illumination system.

8. Illumination system according to one of the preceding claims, **characterized in that** the housing (6) is made from an injection-molded plastic part.

9. Illumination system according to one of the preceding claims, **characterized in that** the plurality of LED modules are also mechanically interconnected via the fastening devices of the LED modules.

10. Illumination system according to one of the preceding claims, **characterized in that** the electrical connecting device (9) of the illumination system is a plug-in connector.

11. Illumination system according to one of the preceding claims, **characterized in that** the electrical connecting device (9) of the illumination system has means (11) for sealing the electrical connecting device (12) of the LED modules.

12. Illumination system according to one of the preceding claims, **characterized in that** the illumination system further has dummy plugs for tightly sealing unused electrical connecting devices (12) of the LED modules.

## Revendications

1. Dispositif d'éclairage présentant plusieurs modules LED qui présentent chacun plusieurs diodes luminescentes disposées sur une carte de circuit,
la carte de circuit (1) présentant au moins un dispositif (12) de raccordement électrique qui permet de raccorder électriquement le module LED par enfichage de préférence libérable et un dispositif de fixation (5) qui permet de fixer le module LED au dispositif d'éclairage de préférence de manière libérable,
les modules LED présentant un boîtier (6) qui entoure les diodes luminescentes disposées sur la carte de circuit (1),
le dispositif d'éclairage présentant un dispositif de fixation qui constitue la pièce complémentaire associée au dispositif de fixation (5) des modules LED et un dispositif de raccordement électrique (9) qui constitue la pièce complémentaire associée au dispositif de raccordement électrique (12) des modules LED,
les modules LED étant reliés électriquement les uns aux autres par les dispositifs (12) de raccordement électrique et chaque dispositif (12) de raccordement électrique présentant un dispositif (3) de contact électrique et un dispositif (7) de contact mécanique de telle sorte que les modules LED peuvent être reliés à une fiche de raccordement (9) par l'intermédiaire du dispositif (12) de raccordement électrique, le dispositif (7) de contact mécanique du dispositif (12) de raccordement électrique étant formé au moyen d'une découpe (7) ménagée dans le boîtier (6) et prévue sur la carte de circuit (1) au-dessus du dispositif (3) de contact électrique.

2. Dispositif d'éclairage selon la revendication 1, **caractérisé en ce que** les modules LED peuvent être reliés mécaniquement les uns aux autres par les dispositifs de fixation des différents modules LED.

3. Dispositif d'éclairage selon la revendication 1 ou 2, **caractérisé en ce que** la fiche de raccordement (9) peut être insérée dans les découpes (7) ménagées dans le boîtier (6).

4. Dispositif d'éclairage selon l'une des revendications précédentes, **caractérisé en ce que** les modules LED présentent en outre une optique (8) qui agit sur la caractéristique d'émission des diodes luminescentes (2).

5. Dispositif d'éclairage selon la revendication 4, **caractérisé en ce que** l'optique (8) est reliée au boîtier (6) ou est intégrée dans le boîtier (6).

6. Dispositif d'éclairage selon l'une des revendications précédentes, **caractérisé en ce qu'**un circuit de commande (4) qui commande les diodes luminescentes (2) est prévu sur la carte de circuit (1).

7. Dispositif d'éclairage selon l'une des revendications précédentes, **caractérisé en ce que** le dispositif de fixation des modules LED (5) permet une fixation libérable des modules LED au dispositif d'éclairage.

8. Dispositif d'éclairage selon l'une des revendications précédentes, **caractérisé en ce que** le boîtier (6) est réalisé sous la forme d'une pièce en matière synthétique moulée par injection.

9. Dispositif d'éclairage selon l'une des revendications précédentes, **caractérisé en ce que** les différents modules LED sont reliés également mécaniquement les uns aux autres par l'intermédiaire des dispositifs de fixation des modules LED.

10. Dispositif d'éclairage selon l'une des revendications précédentes, **caractérisé en ce que** le dispositif (9) de raccordement électrique du dispositif d'éclairage est une fiche de raccordement.

11. Dispositif d'éclairage selon l'une des revendications précédentes, **caractérisé en ce que** le dispositif (9) de raccordement électrique du dispositif d'éclairage présente un moyen (11) qui permet de rendre étanche le dispositif (12) de raccordement électrique des modules LED.

12. Dispositif d'éclairage selon l'une des revendications précédentes, **caractérisé en ce que** le dispositif d'éclairage présente en outre des fiches aveugles qui permettent de fermer hermétiquement les dispositifs (12) de raccordement électrique non utilisés des modules LED.
